**Europäisches Patentamt**

**European Patent Office**

**Office européen des brevets**

(11) Numéro de publication: **0 406 086 A1**

# DEMANDE DE BREVET EUROPEEN

(21) Numéro de dépôt: **90401798.5**

(22) Date de dépôt: **25.06.90**

(51) Int. Cl.5: **H04N 11/08, H04N 7/08**

(30) Priorité: **28.06.89 FR 8908622**

(43) Date de publication de la demande:
**02.01.91 Bulletin 91/01**

(84) Etats contractants désignés:
**DE GB NL**

(71) Demandeur: **ETAT FRANCAIS représenté par le Ministre des Postes, Télécommunications et de l'Espace (CENTRE NATIONAL D'ETUDES DES TELECOMMUNICATIONS), 38-40 rue du Général Leclerc F-92131 Issy-les-Moulineaux(FR)**

Demandeur: **TELEDIFFUSION DE FRANCE 10, rue d'Oradour sur Glane F-75015 Paris(FR)**

(72) Inventeur: **Veillard, Jacques La Viseule Montgermont F-35700 Saint Gregoire(FR)** Inventeur: **Declerck, Christophe 3 Rue aux Ormes Dancourt F-28210 Nogent le Roi(FR)**

(74) Mandataire: **Fort, Jacques et al CABINET PLASSERAUD 84, rue d'Amsterdam F-75009 Paris(FR)**

(54) **Procédé et dispositif de décodage de données duobinaires émises par salves.**

(57) Le procédé et le dispositif sont destinés à décoder des données codées en duobinaire et émises par salves séparées par des intervalles occupés par un signal de nature différente. Le dispositif comprend des moyens pour numériser le multiplex et des moyens de décodage de Viterbi. Ces derniers moyens comprennent deux décodeurs de Viterbi ($34_1$, $34_2$) fonctionnant en parallèle et comportant chacun un détecteur de viol de la règle de codage ; des moyens ($42_1$, $42_2$) pour appliquer aux décodeurs, d'une part les salves et, d'autre part, entre les salves, des signaux +V sur l'un et -V sur l'autre, +V et -V correspondant au codage en duobinaire de la valeur 1 ; et des moyens (46, 48) pour sélectionner, entre les sorties des deux décodeurs, celle du décodeur qui n'a pas détecté un viol de la règle de codage.

EP 0 406 086 A1

## PROCÉDÉ ET DISPOSITIF DE DÉCODAGE DE DONNÉES DUOBINAIRES ÉMISES PAR SALVES

L'invention concerne le décodage de données codées en duobinaire et émises par salves séparées par des intervalles occupés par un signal de nature différente, et elle trouve une application particulièrement importante dans les installations de diffusion de programmes de télévision sous forme d'un multiplex de signaux analogiques d'image et de signaux numériques, codés en duobinaire, de son et de données.

Le brevet principal n° 87 08067 revendique un procédé de décodage de telles données suivant lequel on numérise le multiplex en bande de base et on le soumet à un décodage de Viterbi en masquant les parties du multiplex qui provoqueraient un viol de la règle de codage duobinaire dû aux interruptions entre salves.

Le procédé décrit dans le brevet principal ne donne des résultats optimaux que si on ne décode les derniers échantillons d'une salve que lorsque les premiers échantillons de la salve suivante sont disponibles, ce qui oblige à disposer d'une mémoire ayant une capacité suffisante pour stocker les informations partiellement décodées jusqu'à la salve suivante, d'une ligne à la suivante dans le cas d'un signal de télévision D2-MAC ou D-MAC. Il faut également interrompre le fonctionnement du décodeur pendant les durées séparant les salves et/ou compléter chaque salve par un bit de parité.

L'invention vise notamment à écarter cette nécessité. Dans ce but, elle propose un procédé selon lequel on soumet à deux décodages de Viterbi en parallèle, d'une part, les salves et, d'autre part, entre les salves, l'un des deux niveaux opposés de codage duobinaire de la valeur pour l'un des décodages et l'autre des deux niveaux pour l'autre décodage; et on écarte celle des données fournies par les décodages qui correspond à un viol de la règle de codage duobinaire.

Elle propose également un dispositif permettant de mettre en oeuvre le procédé ci-dessus, comprenant : deux décodeurs de Viterbi fonctionnant en parallèle et comportant chacun un détecteur de viol de la règle de codage ; des moyens pour appliquer aux décodeurs, d'une part les salves et, d'autre part, entre les salves, des signaux +V sur l'un et -V sur l'autre, +V et -V correspondant au codage en duobinaire de la valeur 1 ; et des moyens pour sélectionner, entre les sorties des deux décodeurs, celle du décodeur qui n'a pas détecté un viol de la règle de codage.

Les moyens de sélection sont avantageusement prévus pour conserver la sortie du même décodeur s'il y a détection de viol par les deux décodeurs.

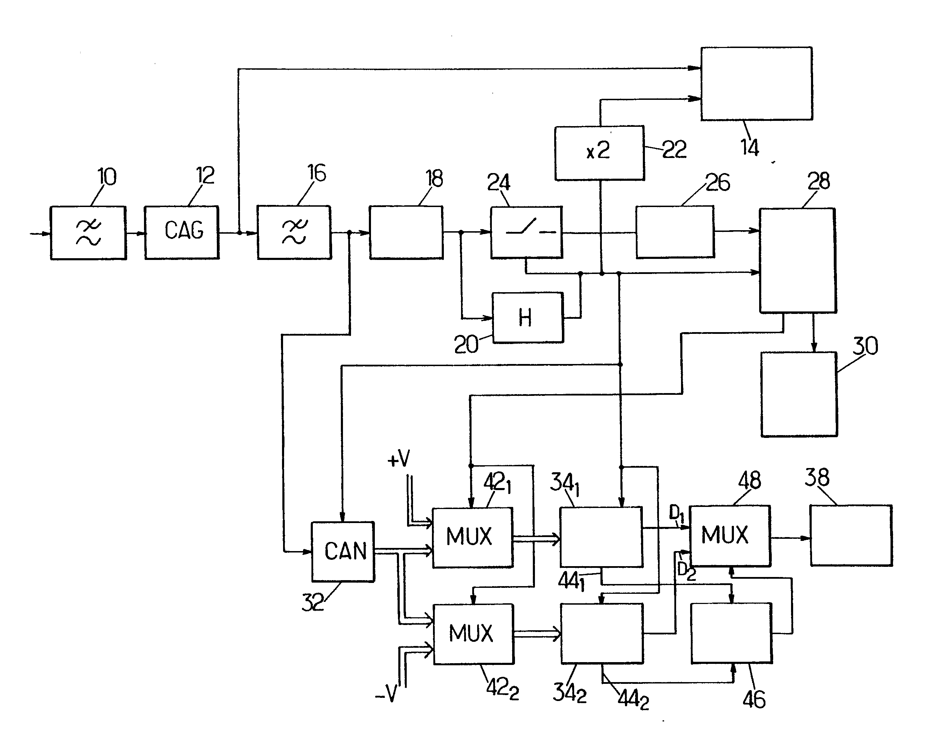

L'invention sera mieux comprise à la lecture de la description qui suit d'un mode particulier de réalisation de l'invention, donné à titre d'exemple non limitatif. La description se réfère à la Figure unique qui l'accompagne et qui est un schéma fonctionnel de dispositif de décodage utilisant deux décodeurs de Viterbi, permettant de décoder des signaux D2 et D-MAC/PAQUET.

On considèrera d'abord, dans ce qui suit, le décodage des signaux de son et de données contenus dans un multiplex conforme à la norme D2-MAC/PAQUET. Ce multiplex a la structure déjà montrée de façon simplifiée dans le brevet 87 08067. Le dispositif de décodage est précédé d'un filtre passe-bas 10 de largeur de bande nominale égale à 8,4 MHz. Le signal filtré est appliqué à un circuit 12 de commande automatique de gain et de restitution de la composante continue. Le signal filtre est ensuite appliqué, d'une part, à un décodeur MAC 14 (destiné à fournir le signal d'image) et, d'autre part, aux circuits qui traitent la composante numérique.

Ces circuits comportent un filtre complémentaire 16 destiné à limiter la bande à 5 MHz environ. Si le récepteur était de type mixte et prévu pour recevoir également des émissions D-MAC, un commutateur pourrait être prévu pour éliminer ce filtre à volonté.

Le signal issu du filtre 16 est appliqué à deux voies de traitement en parallèle.

La première voie comporte un décodeur duobinaire 18 à seuils fixes ou ajustables, un circuit 20 de récupération du signal d'horloge à 10,125 MHz (dont la fréquence est multipliée par deux par un doubleur 22 avant d'être fournie au décodeur MAC 14), un échantillonneur 24 à 10,125 MHz et un circuit de prise de synchronisation 26 alimentant un générateur 28 des fenêtres temporelles requises, constituant la base de temps, ces fenêtres encadrant notamment les salves de données. La première voie comporte encore un circuit 30 de traitement de la ligne 625 permettant de connaître l'affectation des lignes de la suppression trame utilisées pour le télétexte et éventuellement de localiser les salves qui ne sont pas transmises à format fixe.

La deuxième voie, affectée au décodage de Viterbi, comporte un convertisseur analogique/numérique d'entrée 32 qui ne serait pas nécessaire dans le cas d'un décodage à seuils utilisant un critère de décision "dur". Une quantification sur quatre à six bits est généralement suffisante.

Le convertisseur numérique-analogique ou CAN 32 attaque deux branches montées en parallèle et ayant la même constitution. Chacune a un multiplexeur d'entrée $42_1$ ou $42_2$ qui agit en commutateur et permet d'appliquer, sur l'entrée d'un décodeur de Viterbi correspondant $34_1$ ou $34_2$, soit les échantillons numérisés provenant du CAN 32, soit l'un des deux codes représentant nominalement un 1 duobinaire. Ce code fixe est par exemple $+V$ (sous la forme 111 111 en cas de codage sur six bits) pour le multiplexeur $42_1$, $-V$ (dans ce cas, sous la forme 000 000) pour le multiplexeur $42_2$.

Les deux multiplexeurs $42_1$ et $42_2$ sont commandés par le générateur de fenêtres 28 qui maintient la sortie du CAN 32 appliquée aux décodeurs de Viterbi pendant la durée des salves. En dehors de ces durées de salves, les décodeurs $34_1$ et $34_2$ reçoivent des signaux constants, respectivement de niveau $+V$ et $-V$.

Les codeurs de Viterbi peuvent avoir la constitution décrite dans le brevet 87 08067. Ils comprennent un circuit fournissant une impulsion sur une sortie respective $44_1$ ou $44_2$ en cas de violation de la règle de codage. Ces impulsions $V_1$ et $V_2$ sont appliquées à un circuit 46 de commande d'un multiplexeur de données 48. Ce dernier transmet au circuit 38 de traitement des sons et des données, qui assure le débrassage et le désentrelacement des trames et restitue le son et les données, celle des données D1 et D2 qui provient du décodeur pour lequel il n'y a pas eu détection d'un viol de la règle de codage.

Dès le début de chaque salve duobinaire, un des décodeurs $34_1$ et $34_2$ détecte un viol de la règle de décodage, qui se traduit par une erreur double à la sortie de ce décodeur. Ce viol provoque l'émission, sur la sortie $44_1$ ou $44_2$ correspondante, d'une impulsion qui provoque la sélection de l'autre décodeur par le circuit 46.

Etant donné que le viol de la règle de codage est détecté bien avant que la donnée erronée correspondante D1 ou D2 n'apparaisse à la sortie du décodeur de Viterbi (qui introduit habituellement un retard dont la durée est celle de 20 à 40 élément binaires), la sélection par le circuit 46 s'effectue sans difficulté. De même, à la fin de chaque salve, l'un des décodeurs fournit une impulsion indiquant un viol de la règle de codage au circuit 46 qui sélectionne alors les données sortant de l'autre décodeur.

Avec ce dispositif, les salves reçues sont décodées comme en mode continu, le signal d'horloge étant appliqué en permanence aux décodeurs $34_1$ et $34_2$. Les données estimées apparaissent à la sortie avec un retard correspondant à la longueur du registre nécessaire dans les décodeurs pour mettre en mémoire les suivants (20 à 40 éléments binaires).

La relation entre les signaux $V_1$ et $V_2$ issus des détecteurs de viol des décodeurs $34_1$ et $34_2$ et les signaux $I_A$ et $I_B$ de sélection de la sortie D1 ou D2 des décodeurs de Viterbi est donnée par le Tableau :

| $V_{1N}$ | $V_{2N}$ | $I_{AN}$ | $I_{BN}$ | $D_N$ |
|---|---|---|---|---|
| 1 | 0 | 0 | 1 | $D_{BN}$ |
| 0 | 1 | 1 | 0 | $D_{AN}$ |
| 0 | 0 | $I_{A(N-1)}$ | $I_{B(N-1)}$ | $D_{(N-1)}$ |
| 1 | 1 | $I_{A(N-1)}$ | $I_{B(N-1)}$ | $D_{(N-1)}$ |

où N-1 et N correspondent à deux échantillons successifs. Ceci correspond aux équations logiques suivantes :

$$I_{AN} = I_{AN-1} (V_{AN} V_{BN} + \overline{V}_{AN} \overline{V}_{BN}) + \overline{V}_{AN} V_{BN}$$
$$I_{BN} = I_{BN-1} (V_{AN} V_{BN} + \overline{V}_{AN} \overline{V}_{BN}) + V_{AN} \overline{V}_{BN}$$

On voit que la sortie précédemment sélectionnée est conservée si les deux détecteurs de viol fournissent des informations $V_{1N}$ et $V_{2N}$ contradictoires.

La mise en oeuvre de l'invention permet d'écarter la nécessité d'une mémoire de grande capacité et de moyens annexes d'interruption du fonctionnement du décodeur de Viterbi, en ajoutant simplement des composants de nature simple, constitués par un détecteur de Viterbi et des multiplexeurs. Une simulation a montré qu'il n'y a aucune dégradation des résultats par rapport à ceux obtenus par mise en oeuvre du dispositif décrit à titre d'exemple dans le brevet principal.

Les dispositions décrites sont directement transposables au décodage des salves de données d'un multiplex D-MAC/PAQUET, sans qu'il soit utile d'ajouter un bit de parité à la fin de chaque salve. Là encore, chaque décodeur de Viterbi est simplement forcé à $+V$ ou $-V$ pendant les intervalles entre salves.

**Revendications**

1. Procédé de décodage de données codées en duobinaire et émises par salves séparées par des intervalles occupés par un signal de nature différente, suivant lequel on numérise le multiplex en bande de base et on le soumet à un décodage de Viterbi en masquant les parties du multiplex qui provoqueraient un viol de la règle de codage duobinaire dû aux interruptions entre salves, caractérisé en ce qu'on soumet à deux décodages de Viterbi en parallèle, d'une part, les salves et, d'autre part, entre les salves, l'un des deux niveaux opposés de codage duobinaire de la valeur pour l'un des décodages et l'autre des deux niveaux pour l'autre décodage; et on écarte celle des données fournies par les décodages qui correspond à un viol de la règle de codage duobinaire.

2. Procédé selon la revendication 1, caractérisé en ce que, un niveau 1 de V indiquant un viol de la règle de codage, D indiquant la donnée sélectionnée, les indices 1 et 2 indiquant les deux décodages et N indiquant la donnée d'ordre N, la sélection est effectuée suivant le tableau :

| $V_{1N}$ | $V_{2N}$ | $D_N$ |
|----------|----------|-------|
| 1 | 0 | $D_{BN}$ |
| 0 | 1 | $D_{AN}$ |
| 0 | 0 | $D_{N-1}$ |
| 1 | 1 | $D_{N-1}$ |

3. Dispositif de décodage de données codées en duobinaire et émises par salves séparées par des intervalles occupés par un signal de nature différente, permettant de mettre en oeuvre le procédé selon la revendication 1, comprenant des moyens pour numériser le multiplex et des moyens de décodage de Viterbi, caractérisé en ce que lesdits moyens de décodage comprennent deux décodeurs de Viterbi ($34_1$, $34_2$) fonctionnant en parallèle et comportant chacun un détecteur de viol de la règle de codage ; des moyens ($42_1$, $42_2$) pour appliquer aux décodeurs, d'une part les salves et, d'autre part, entre les salves, des signaux +V sur l'un et -V sur l'autre, +V et -V correspondant au codage en duobinaire de la valeur 1 ; et des moyens (46, 48) pour sélectionner, entre les sorties des deux décodeurs, celle du décodeur qui n'a pas détecté un viol de la règle de codage.

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| D,A | EP-A-0 295 974 (TDF)<br>* Page 3, ligne 26 - page 8, ligne 51 *<br>--- | 1,3 | H 04 N 11/08<br>H 04 N 7/08 |
| A | EP-A-0 296 914 (TDF)<br>* Page 6, ligne 43 - page 7, ligne 13 *<br>--- | 1,3 | |
| A | EP-A-0 278 171 (FERGUSSON LTD)<br>* Résumé; page 9, lignes 10-16 *<br>----- | 1 | |

DOMAINES TECHNIQUES
RECHERCHES (Int. Cl.5)

H 04 N

Le présent rapport a été établi pour toutes les revendications

| Lieu de la recherche | Date d'achèvement de la recherche | Examinateur |
|---|---|---|
| LA HAYE | 08-10-1990 | BOSCH F.M.D. |

CATEGORIE DES DOCUMENTS CITES

X : particulièrement pertinent à lui seul
Y : particulièrement pertinent en combinaison avec un
    autre document de la même catégorie
A : arrière-plan technologique
O : divulgation non-écrite
P : document intercalaire

T : théorie ou principe à la base de l'invention
E : document de brevet antérieur, mais publié à la
    date de dépôt ou après cette date
D : cité dans la demande
L : cité pour d'autres raisons
........................................................................
& : membre de la même famille, document correspondant

EPO FORM 1503 03 82 (P0402)